# EUROPÄISCHE PATENTSCHRIFT

(11) **EP 2 695 073 B1**
(45) Veröffentlichungstag und Bekanntmachung des Hinweises auf die Patenterteilung: **14.09.2016**
(21) Anmeldenummer: 12713079.7
(22) Anmeldetag: 29.03.2012
(51) Int. Cl.: G06F 13/42, H04L 12/413, G06F 11/00

(54) **VERFAHREN UND VORRICHTUNG ZUR ANPASSUNG DER DATENÜBERTRAGUNGSSICHERHEIT IN EINEM SERIELLEN BUSSYSTEM**
METHOD AND APPARATUS FOR ADAPTING THE DATA TRANSMISSION SECURITY IN A SERIAL BUS SYSTEM
PROCÉDÉ ET DISPOSITIF D'ADAPTATION DE LA SÉCURITÉ DE TRANSMISSION DE DONNÉES DANS UN SYSTÈME DE BUS SÉRIEL

(30) Priorität: 06.04.2011 DE 102011006875; 29.06.2011 DE 102011078266; 05.08.2011 DE 102011080476
(43) Veröffentlichungstag der Anmeldung: 12.02.2014
(73) Patentinhaber: Robert Bosch GmbH, 70442 Stuttgart (DE)
(72) Erfinder: HARTWICH, Florian, 72762 Reutlingen (DE)
(86) Internationale Anmeldenummer: PCT/EP2012/055574
(87) Internationale Veröffentlichungsnummer: WO 2012/136545

(56) Entgegenhaltungen:
- DE-A1-102004 055 684
- "Road vehicles - Controller area network (CAN) - Part 1: Data link layer and physical signalling ; ISO 11898-1-2003", IEEE DRAFT; ISO+11898-1-2003, IEEE-SA, PISCATAWAY, NJ USA, Bd. msc.upamd, 18. November 2010 (2010-11-18), Seiten 1-52, XP017637056,

## Beschreibung

### Stand der Technik

Die Erfindung betrifft ein Verfahren sowie eine Vorrichtung zur Anpassung der Datenübertragungssicherheit zwischen wenigstens zwei Teilnehmern in einem seriellen Bussystem.

Beispielsweise aus den Normen der Familie ISO 11898-1 bis -5 ist das Controller Area Network (CAN) sowie eine als "Time Triggered CAN" (TTCAN) bezeichnete Erweiterung des CAN bekannt, im Folgenden auch als Norm CAN bezeichnet. Das beim CAN verwendete Medienzugriffssteuerverfahren beruht auf einer bitweisen Arbitrierung. Bei der bitweisen Arbitrierung können mehrere Teilnehmerstationen gleichzeitig Daten über den Kanal des Bussystems übertragen, ohne dass hierdurch die Datenübertragung gestört wird. Die Teilnehmerstationen können weiterhin beim Senden eines Bits über den Kanal den logischen Zustand (0 oder 1) des Kanals ermitteln. Entspricht ein Wert des gesendeten Bits nicht dem ermittelten logischen Zustand des Kanals, dann beendet die Teilnehmerstation den Zugriff auf den Kanal. Bei CAN wird die bitweise Arbitrierung üblicherweise anhand eines Identifiers innerhalb einer über den Kanal zu übertragenden Nachricht vorgenommen. Nachdem eine Teilnehmerstation den Identifier vollständig an den Kanal gesendet hat, weiß sie, dass sie exklusiven Zugriff auf den Kanal hat. Somit entspricht das Ende der Übertragung des Identifiers einem Beginn eines Freigabeintervalls, innerhalb dessen die Teilnehmerstation den Kanal exklusiv nutzen kann. Gemäß der Protokollspezifikation des CAN dürfen andere Teilnehmerstationen so lange nicht auf den Kanal zugreifen, das heißt Daten an den Kanal senden, bis die sendende Teilnehmerstation ein Prüfsummenfeld (CRC Field) der Nachricht übertragen hat. Somit entspricht ein Endzeitpunkt der Übertragung des CRC Fields einem Ende des Freigabeintervalls.

Durch die bitweise Arbitrierung wird also eine zerstörungsfreie Übertragung derjenigen Nachrichten über den Kanal erreicht, die das Arbitrierungsverfahren gewonnen hat. Die Protokolle des CAN eignen sich besonders zum Übertragen kurzer Meldungen unter Echtzeitbedingungen, wobei durch geeignete Zuweisung der Identifier sichergestellt werden kann, dass besonders wichtige Nachrichten nahezu immer die Arbitrierung gewinnen und erfolgreich gesendet werden.

Mit der zunehmenden Vernetzung moderner Fahrzeuge und dem Einzug zusätzlicher Systeme zur Verbesserung beispielsweise der Fahrsicherheit oder des Fahrkomforts wachsen die Anforderungen an die zu übertragenden Datenmengen und die bei der Übertragung zulässigen Latenzzeiten. Beispiele sind Fahrdynamikregelsysteme wie z.B. das elektronische Stabilitätsprogramm ESP, Fahrerassistenzsysteme wie z.B. die automatische Abstandsregelung ACC, oder Fahrerinformationssysteme wie z.B. die Verkehrszeichenerkennung (vgl. beispielsweise Beschreibungen in "Bosch Kraftfahrtechnisches Handbuch", 27. Auflage, 2011, Vieweg+Teubner).

DE 103 11 395 A1 beschreibt ein System, bei welchem asynchrone, serielle Kommunikation alternativ über ein asymmetrisches physikalisches oder über das symmetrische physikalische CAN-Protokoll erfolgen kann, und dadurch eine höhere Datenübertragungsrate oder -sicherheit für die asynchrone Kommunikation erzielbar ist.

DE 10 2007 051 657 A1 schlägt vor, in den exklusiven Zeitfenstern des TTCAN Protokolles eine asynchrone, schnelle, nicht CAN-konforme Datenübertragung anzuwenden, um die übertragene Datenmenge zu erhöhen.

DE 10 2004 055 684 A1 offenbart eine Möglichkeit zur Nutzung unterschiedlich großer CRC-Checksummen beim Austausch von Nachrichten unterschiedlicher Länge, wobei jeweils die Software in Sender und Empfänger die Länge des Datenfeldes auswertet und abhängig davon die CRC auf unterschiedliche Art und Weise berechnet. Die Prüfung der Korrektheit der CRC erfolgt im Empfänger nach Empfang der vollständigen Nachricht. Es wird keine Reaktion auf die Feststellung einer korrekten oder nicht korrekten Übertragung beschrieben.

G. Cena und A. Valenzano behandeln in "Overclocking of controller area networks" (Electronics Letters, Vol. 35, No. 22 (1999), S. 1924) die Auswirkungen einer Übertaktung der Busfrequenz in Teilbereichen der Nachrichten auf die effektiv erzielte Datenrate. Die Anpassung der Datenübertragungssicherheit wird nicht behandelt.

Es zeigt sich, dass der Stand der Technik nicht in jeder Hinsicht befriedigende Ergebnisse liefert.

### Offenbarung der Erfindung

Im Folgenden wird die Erfindung mit ihren Vorteilen anhand von Zeichnungen und Ausführungsbeispielen beschrieben. Der Gegenstand der Erfindung ist nicht auf die dargestellten und geschilderten Ausführungsbeispiele beschränkt.

### Vorteile der Erfindung

Die vorliegende Erfindung geht aus von der Übertragung von Nachrichten mit einem logischen Aufbau nach dem CAN Standard ISO 11898-1 in einem Bussystem mit mindestens zwei teilnehmenden Datenverarbeitungseinheiten, wobei der logische Aufbau ein Start-of-Frame-Bit, ein Arbitration Field, ein Control Field, ein Data Field, ein CRC Field, ein Acknowledge Field und eine End-of-Frame Sequenz umfasst, und wobei das Control Field einen Data Length Code umfasst, der eine Information über die Länge des Data Fields enthält.

Die Erfindung stellt eine Möglichkeit bereit, für bestimmte übertragene Nachrichten ein geändertes Polynom zur Berechnung der Checksumme heranzuziehen und ein CRC Field mit einer vom Norm CAN abweichenden Größe zu übertragen, indem in Abhängigkeit vom Wert einer zugeordneten Umschaltbedingung das CRC Field der Nachrichten wenigstens zwei unterschiedliche Anzahlen von Bits aufweisen kann. Dadurch kann abhängig von der Umschaltbedingung die Datenübertragung an die jeweils vorliegende Datenübertragungsaufgabe, beispielsweise an den Umfang oder die Sicherheitsrelevanz der übertragenen Daten angepasst und somit die Datenübertragungssicherheit beeinflusst beziehungsweise festgelegt werden. Vorteilhafterweise werden hierbei zur Festlegung des Inhaltes des CRC Field in Abhängigkeit vom Wert der zugeordneten Umschaltbedingung wenigstens zwei unterschiedliche Generator-Polynome verwendet.

Hinsichtlich des Einsatzes des erfindungsgemäßen Verfahrens und der entsprechenden Vorrichtungen auch in herkömmlichen CAN Netzwerken ist es von Vorteil, wenn für wenigstens einen Wert der zugeordneten Umschaltbedingung die Anzahl von Bits im CRC Field und das zur Festlegung des Inhaltes des CRC Field verwendete Generator-Polynom der CAN-Norm ISO 11898-1 entsprechen.

In einer vorteilhaften Ausführungsform sind die entsprechenden Nachrichten durch eine geeignete Kennzeichnung im Arbitration Field und/oder im Control Field erkennbar. Dadurch können die die Nachricht empfangenden Teilnehmer die erfindungsgemäß modifizierten Nachrichten erkennen und ihren Empfangsprozess darauf anpassen. Es kann vorteilhaft sein, wenn für diese Anpassung auch der Inhalt des Data Length Code verwendet wird.

In einer besonders vorteilhaften Ausführungsform werden zu Beginn einer Nachricht parallel mehrere Berechnungen von Checksummen gestartet und es wird abhängig vom Vorliegen einer zugeordneten Umschaltbedingung und / oder dem Inhalt des Data Length Code entschieden welches Ergebnis einer dieser Berechnungen verwendet beziehungsweise im CRC Field übertragen wird. Dadurch ist es möglich, die Information darüber, ob eine Nachricht nach dem Norm-gemäßen Verfahren oder nach dem erfindungsgemäß modifizierten Verfahren übertragen wird, mit der Nachricht zu versenden, ohne die Empfänger im Voraus über das verwendete Verfahren zu informieren. Die Checksummen zur Prüfung der korrekten Datenübertragung liegen für beide Verfahren vor und können nach Bedarf ausgewertet werden.

Eine vorteilhafte Ausführungsform erzielt durch die Bereitstellung einer Möglichkeit zur Vergößerung des Datenfeldes einer übertragenen Nachricht den Effekt, dass gegenüber einer normgemäßen CAN Nachricht eine größere Menge an Daten mit einer einzigen Nachricht über den Bus übermittelt werden kann. Somit steigt in vorteilhafter Weise das Verhältnis von Datenmenge zu Kontrollinformation in einer Nachricht, und somit auch die mittlere Datenübertragungsrate über das Bussystem. Die Kombination mit der erfindungsgemäßen Anpassung des CRC Field hat den Vorteil, dass die Sicherheit der Fehlererkennung auch für größere übertragene Datenmengen erhalten bleibt beziehungsweise angepasst werden kann.

Durch das Aufstellen einer eindeutigen Zuordnung zwischen dem Inhalt des Data Length Code und der Länge des Datenfeldes wird in vorteilhafter Weise eine hohe Flexibilität bezüglich der darstellbaren Größe des Datenfeldes erreicht.

Es ist weiterhin von Vorteil, dass für die im Norm CAN üblicherweise genutzten Werte 0b0001 bis 0b1000 des Data Length Code die dem Norm CAN entsprechenden Größen des Datenfeldes, also 1 Byte bis 8 Byte zugeordnet werden und die restlichen Werte des Data Length Code für die weiteren zulässigen Größen des Datenfeldes bis zur maximal möglichen Größe genutzt werden. Dies verringert den Anpassungsaufwand von Anwendungssoftware bei der Umstellung auf das erfindungsgemäße Verfahren in kostensparender Weise.

Die Verwendung eines geänderten Polynoms zur Berechnung der Checksumme erfolgt in Abhängigkeit von einer Umschaltbedingung, so dass bei Vorliegen der Umschaltbedingung das erfindungsgemäße Verfahren zur Anwendung kommt, während sonst die Datenübertragung gemäß dem normalen CAN Standard erfolgt. Ebenfalls vorteilhaft erfolgt auch die Vergrößerung des Datenfeldes und die Anpassung der Interpretation des Inhaltes des Data Length Code in gleicherweise abhängig von einer, eventuell derselben Umschaltbedingung. Dadurch können erfindungsgemäßen Vorrichtungen sowohl in Standard CAN Bussystemen eingesetzt werden, als auch in neuen, erfindungsgemäßen Bussystemen mit potenziell größeren Datenfeldern.

Die vorliegenden Umschaltbedingungen werden durch eine oder mehrere Kennzeichnungen den Empfängern mitgeteilt. Hier ist es besonders vorteilhaft, wenn wenigstens eine der Kennzeichnungen durch ein erstes Kennzeichen-Bit erfolgt, dessen Position zwischen dem letzten Bit des Identifiers und dem ersten Bit des Data Length Code liegt und an dessen Position sich in Nachrichten gemäß der CAN-Norm ISO 11898-1 ein Bit mit einem festgelegten Wert befindet. Es ist weiter von Vorteil, dass eventuell vorhandene Stuff-Bits, welche vor dem CRC Field in der Nachricht auftreten, in die Berechnung der Checksumme mit aufgenommen werden. Hierdurch wird die Sicherheit der Datenübertragung beziehungsweise die Erkennungswahrscheinlichkeit für Datenübertragungsfehler weiter verbessert.

Kombiniert man das Verfahren weiter mit einer Umschaltung der Bitlänge beispielsweise für zumindest die Bits des Datenfeldes und des CRC Feldes, so erzielt man den weiteren Vorteil, dass eine größere Menge an Daten beschleunigt übertragen wird, als dies bei einer Begrenzung des Datenfeldes auf 8 Byte der Fall ist. Dadurch wird die mittlere Datenübertragungsrate des Bussystems weiter gesteigert. In einer vorteilhaften Ausprägung erfolgt in diesem Fall eine Kennzeichnung der Nachrichten mit verkürzter Bitlänge durch ein weiteres Kennzeichen-Bit, welches zwischen dem ersten Kennzeichen-Bit und dem ersten Bit des Data Length Code liegt. Dadurch kann die Umschaltung der Bitlänge unabhängig von der Umschaltung der CRC Berechnung beziehungsweise der Größe des Datenfeldes erfolgen und es kann flexibel auf Gegebenheiten des Bussystems reagiert werden.

Das Verfahren ist vorteilhaft einsetzbar im normalen Betrieb eines Kraftfahrzeuges zur Übertragung von Daten zwischen wenigstens zwei Steuergeräten des Kraftfahrzeuges, welche über einen geeigneten Datenbus verbunden sind. Es ist aber gleichermaßen vorteilhaft einsetzbar während der Fertigung oder Wartung eines Kraftfahrzeuges zur Übertragung von Daten zwischen einer zum Zwecke der Programmierung mit einem geeigneten Datenbus verbundenen Programmierungseinheit und wenigstens einem Steuergerät des Kraftfahrzeuges, welches mit dem Datenbus verbunden ist. Es ist ebenfalls vorteilhaft einsetzbar im industriellen Bereich, wenn größere Datenmengen beispielsweise zu Steuerungszwecken übertragen werden müssen. Insbesondere, wenn aufgrund der Länge der Übertragungsstrecke während der Arbitrierung eine reduzierte Datenrate angewendet werden muss, damit alle Teilnehmer die Möglichkeit haben, den Zugriff auf den Bus zu erhalten, kann durch das Verfahren, insbesondere in Kombination mit der Umschaltung der Länge des Datenfeldes und der Reduktion der Bitlänge, eine höhere Datenübertragungsrate erzielt werden.

Ein weiterer Vorteil ist, dass ein Norm-CAN Controller nur minimal geändert werden muss, um erfindungsgemäß arbeiten zu können. Ein erfindungsgemäßer Kommunikationscontroller, der auch als Norm-CAN Controller arbeiten kann, ist nur unwesentlich größer als ein herkömmlicher Norm-CAN Controller. Das zugehörige Anwendungs-Programm muss nicht geändert werden, und schon dann werden Vorteile in der Geschwindigkeit der Datenübertragung erzielt.

Es können in vorteilhafter Weise erhebliche Teile des CAN-Conformance-Tests (ISO 16845) übernommen werden. In einer vorteilhaften Ausprägung kann das erfindungsgemäße Übertragungsverfahren mit den Ergänzungen des TTCAN (ISO 11898-4) kombiniert werden.

### Zeichnungen

Die Erfindung wird im Weiteren anhand der Zeichnungen näher erläutert.
Figur 1a zeigt die zwei Alternativen für den Aufbau von Nachrichten im CAN Format gemäß der CAN-Norm ISO 11898-1 aus dem Stand der Technik. Figur 1b zeigt die zwei analogen Alternativen für das Format der demgegenüber erfindungsgemäß modifizierten Nachrichten.
Figur 2 stellt verschiedene Möglichkeiten dar, wie der Inhalt des Data Length Code erfindungsgemäß abweichend von der CAN-Norm ISO 11898-1 interpretiert werden kann.
Figur 3 stellt schematisch ein Ausführungsbeispiel für den erfindungsgemäßen Empfangsprozess auf einer Teilnehmerstation des Bussystems dar.
Figur 4 stellt schematisch ein weiteres Ausführungsbeispiel für den erfindungsgemäßen Empfangsprozess auf einer Teilnehmerstation des Bussystems dar.
Figur 5 zeigt zwei Beispiele für das Format von erfindungsgemäß modifizierten Nachrichten, bei denen zusätzlich in festgelegten Bereichen innerhalb der Nachricht eine unterschiedliche Bitlänge verwendet wird.

### Beschreibung der Ausführungsbeispiele

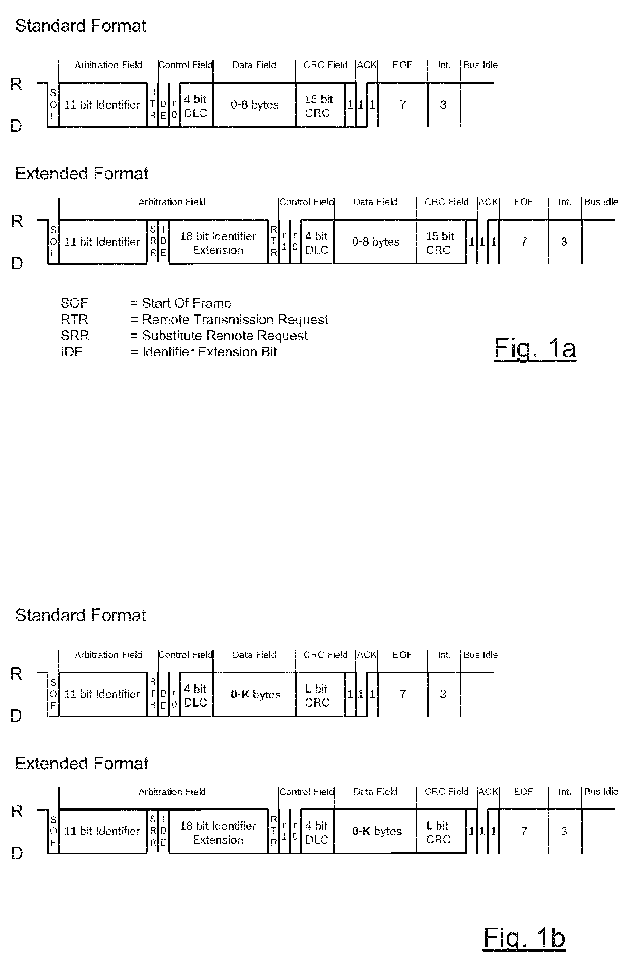

In Figur 1a ist der Aufbau von Nachrichten, wie sie auf einem CAN Bus zur Datenübertragung verwendet werden, dargestellt. Die beiden unterschiedlichen Formate "Standard" und "Extended" sind dargestellt. Das erfindungsgemäße Verfahren ist auf beide Formate gleichermaßen anwendbar.

Die Nachricht beginnt mit einem "Start of Frame"(SOF)-Bit, das den Beginn der Nachricht signalisiert. Es schließt sich ein Abschnitt an, der in erster Linie zur Identifizierung der Nachricht dient, und anhand dessen die Teilnehmer des Bussystems entscheiden, ob sie die Nachricht empfangen oder nicht. Dieser Abschnitt wird mit "Arbitration Field" bezeichnet und enthält den Identifier. Es folgt ein "Control Field", das unter anderem den Data Length Code enthält. Der Data Length Code enthält Informationen über die Größe des Datenfeldes der Nachricht. Hieran schließt sich das eigentliche Datenfeld "Data Field" an, das die zwischen den Teilnehmern des Bussystems auszutauschenden Daten enthält. Es folgt das "CRC Field" mit der 15 Bit umfassenden Checksumme und einem Delimiter, und anschließend zwei "Acknowledge"(ACK)-Bits, die dazu dienen, den erfolgreichen Empfang einer Nachricht an den Sender zu signalisieren. Abgeschlossen wird die Nachricht durch eine "End of Frame"(EOF)-Sequenz.

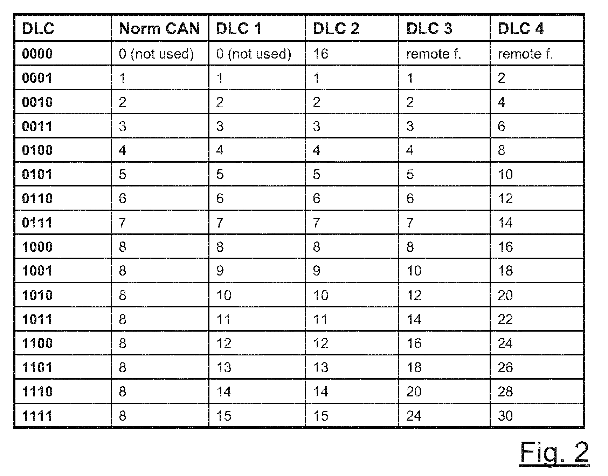

Bei dem CAN Übertragungsverfahren nach der Norm darf das Datenfeld maximal 8 Byte, also 64 Bit an Daten enthalten. Der Data Length Code umfasst gemäß der Norm vier Bits, kann also 16 verschiedene Werte annehmen. Benutzt werden aus diesem Wertebereich in heutigen Bussystemen lediglich acht verschiedene Werte für die unterschiedlichen Größen des Datenfeldes von 1 Byte bis zu 8 Byte. Ein Datenfeld von 0 Byte ist im Norm CAN nicht empfohlen, Größen oberhalb von 8 Byte sind nicht zulässig. Die Zuordnung der Werte des Data Length Code zu den Größen des Datenfeldes ist in Figur 2 in der Spalte CAN Norm dargestellt.

In Figur 1b sind in analoger Darstellung die erfindungsgemäß zu übertragenden, modifizierten Nachrichten, jeweils abgeleitet von den beiden Norm-Formaten, gegenübergestellt.

Bei dem erfindungsgemäß modifizierten Übertragungsverfahren darf das Datenfeld auch mehr als 8 Byte enthalten, nämlich in der dargestellten Ausprägung bis zu K Byte. Anders als im Norm CAN werden weitere Werte, die der Data Length Code einnehmen kann, ausgenutzt, um größere Datenfelder zu kennzeichnen. Beispielsweise können die vier Bits des Data Length Code benutzt werden, um die Werte von null bis 15 Byte darzustellen. Es können aber auch andere Zuordnungen getroffen werden, beispielsweise ist es eine Möglichkeit, den in heutigen CAN-Nachrichten üblicherweise nicht genutzten Wert des Data Length Code DLC = 0b0000 für eine weitere mögliche Größe des Datenfeldes zu benutzen, beispielsweise für die Größe 16 Byte. Diese beiden Möglichkeiten sind in Figur 2 in Tabellenform als DLC 1 und DLC 2 dargestellt. Die Maximalgröße des Datenfeldes K hat in diesen Fällen den Wert 15 bzw. 16.

Eine weitere Möglichkeit ist es, dass für die Werte des Data Length Code größer 0b1000 und bis 0b1111 die zugehörigen Größen des Datenfeldes um beispielsweise jeweils 2 Byte anwachsen. Dieser Fall ist in der Tabelle als DLC 3 dargestellt. Die Maximalgröße des Datenfeldes K erreicht in dieser Variante den Wert 24. Durch Wahl eines größeren Inkrements, beispielsweise 4 Byte, wären entsprechend größere Datenfelder erreichbar.

Im Beispiel DLC3 ist außerdem noch eine weitere Modifikation vorgenommen: der Wert DLC = 0b0000 wird in diesem Ausführungsbeispiel von Remote-Frames verwendet. Im Norm CAN ist es demgegenüber vorgesehen, dass ein Remote-Frame mit demselben Wert des DLC gesendet wird, welchen die als Reaktion auf den Remote-Frame versendete Nachricht aufweist. Durch die hier beschriebene Modifikation wird sichergestellt, dass nicht Remote-Frames mit unterschiedlicher DLC und gleichem Identifier versendet werden können, was (vgl. ISO 11898-1, Kap. 10.8.8) zu unauflösbaren Kollisionen führen kann.

In den Ausprägungen des Verfahrens, die in Figur 2 in den Spalten DLC 1, DLC 2 und DLC 3 tabellenartig dargestellt sind, entspricht die Zuordnung der Werte von 0b0001 bis 0b1000 des Data Length Code zu Größen des Datenfeldes zwischen 1 Byte und 8 Byte der Zuordnung im Norm CAN. Dadurch ist es in einfacher Weise möglich, Kompatibilität zum Norm CAN zu erreichen, also den Kommunikationscontroller so auszulegen, dass er in einem Norm CAN Bussystem normgemäß arbeitet, während er in einem erfindungsgemäß modifizierten Bussystem größere Datenfelder in den Nachrichten zulässt. Es ist aber auch möglich, eine vollkommen neue Zuordnung der möglichen Werte des Data Length Code zu zulässigen Größen des Datenfeldes vorzunehmen. Ein Beispiel hierfür ist als DLC 4 ebenfalls in Figur 2 aufgeführt. Die erreichte Maximalgröße K des Datenfeldes ist in diesem Fall 30 Bytes.

Um zu gewährleisten, dass ein solcher Kommunikationscontroller feststellen kann, in welcher Art er die Inhalte des Data Length Code zu interpretieren hat, ist vorteilhaft, dass er selbständig erkennt, ob die Kommunikation des Bussystems nach Norm CAN oder dem erfindungsgemäßen Verfahren abläuft. Eine Möglichkeit hierzu besteht darin, ein reserviertes Bit innerhalb des Arbitration Field oder des Control Field zur Kennzeichnung heranzuziehen, so dass aus dieser ersten Kennzeichnung K1 der Kommunikationscontroller eine erste Umschaltbedingung UB1 ableiten kann, abhängig von der er das Übertragungsverfahren auswählt. Beispielsweise kann das in Figur 1b mit r0 bezeichnete, zweite Bit des Control Field zur Kennzeichnung verwendet werden.

Die Festlegung kann auch abhängig vom Identifier-Format gewählt werden. Für Standard Adressierung ist so eine Möglichkeit zur Kennzeichnung der erfindungsgemäßen Nachrichten das Einfügen eines rezessiven EDL-Bits (Extended Data Length) in das Control Field an der Position des im Norm-CAN stets dominanten r0-Bits. Für Extended Adressierung kann das rezessive EDL-Bits im Control Field an die Position des im Norm-CAN stets dominanten r1-Bits treten.

Eine andere Möglichkeit ist, das SRR-Bit zu verwenden, welches im Norm CAN immer rezessiv gesendet werden muss, aber von den die Nachricht empfangenden Busteilnehmern auch dominant akzeptiert wird. Es können auch Bitkombinationen zur Feststellung der ersten Umschaltbedingung UB1 ausgewertet werden.

Eine weitere Möglichkeit wäre, für das erfindungsgemäß modifizierte Übertragungsverfahren die Verwendung des Extended Formates vorzuschreiben. Nachrichten im Extended Format werden von den Busteilnehmern am Wert des IDE-Bits erkannt (vgl. Figur 1a) und dieses Bit könnte gleichzeitig die erste Umschaltbedingung UB1 darstellen, so dass für Extended Nachrichten immer das modifizierte Übertragungsverfahren zur Anwendung kommt. Alternativ wäre es auch möglich, in Extended Nachrichten das reservierte Bit r1 als erste Kennzeichnung K1 beziehungsweise zur Ableitung der ersten Umschaltbedingung UB1 zu verwenden. Das reservierte Bit kann aber auch, wie weiter unten ausgeführt, zur Ableitung einer zweiten Umschaltbedingung UB2 zur Umschaltung zwischen mehr als zwei verschiedenen Größen des Datenfeldes beziehungsweise Zuordnungen zwischen Werten des Data Length Code und Datenfeldgrößen genutzt werden.

Es ist alternativ aber auch möglich, das Verfahren in dazu geeigneten Kommunikationscontrollern zur Anwendung zu bringen, die nicht auch zur normgemäßen CAN Kommunikation ausgelegt sind. In diesem Fall kann auch die Festlegung der genannten ersten Umschaltbedingung UB1, beispielsweise abhängig von einer geeigneten Kennzeichnung K1 der Nachrichten, entfallen. Die Kommunikationscontroller arbeiten in diesem Fall vielmehr ausschließlich gemäß einem der beschriebenen Verfahren und sind dementsprechend nur in Bussystemen einsetzbar, in welchen ausschließlich solche erfindungsgemäßen Kommunikationscontroller im Einsatz sind.

Wird, wie in der Erfindung vorgesehen, das Datenfeld von Nachrichten vergrößert, so kann es sinnvoll sein, auch das verwendete Verfahren zum Cyclic Redundancy Check (CRC) anzupassen, um eine ausreichende Fehlersicherheit zu erhalten. Insbesondere kann es vorteilhaft sein, ein anderes CRC-Polynom, beispielsweise mit höherer Ordnung, zu verwenden und entsprechend eine CRC Field abweichender Größe in den erfindungsgemäß modifizierten Nachrichten vorzusehen. Dies ist in Figur 1b dadurch dargestellt, dass das CRC Field der erfindungsgemäßen Nachrichten im dargestellten Beispiel eine Länge von L Bit aufweist, wobei L abweichend vom Norm CAN ungleich, insbesondere größer als 15 sein kann.

Die Verwendung eines modifizierten Verfahrens zur Berechnung der CRC Checksumme kann durch eine dritte Kennzeichnung K3, welche eine dritte Umschaltbedingung UB3 darstellt, den Busteilnehmern signalisiert werden. Diese Kennzeichnung K3 und die dritte Umschaltbedingung UB3 kann aber auch mit der ersten Kennzeichnung K1 und / oder Umschaltbedingung UB1 übereinstimmen. Auch hier kann, wie weiter oben beschrieben, beispielsweise das reservierte Bit r0 aus Figur 1b zur Kennzeichnung dienen, oder es kann das SRR-Bit verwendet werden. Auch eine Verwendung des IDE-Bit in Verbindung mit der Anwendung des Verfahrens in Extended Nachrichten, oder auch des Bit r1 kommt in Frage.

In den Norm CAN-Controllern wird der CRC-Code von zu sendenden CAN-Nachrichten mittels eines rückgekoppelten Schieberegisters erzeugt, in dessen Eingang die seriell gesendeten Bits der Nachricht sequenziell eingespeist werden. Die Breite des Schieberegisters entspricht der Ordnung des CRC-Polynoms. Die CRC-Codierung erfolgt durch eine Verknüpfung des Register-Inhalts mit dem CRC-Polynom während der Shift-Operationen. Wenn CAN-Nachrichten empfangen werden, werden entsprechend die seriell empfangenen Bits der Nachricht in das CRC-Schieberegister geschoben. Der CRC-Test ist erfolgreich, wenn am Ende des CRC-Feldes alle Bits des Schieberegisters auf Null stehen. Die CRC-Code-Generierung im Sendefall und der CRC-Test im Empfangsfall erfolgen beide in Hardware, ohne dass ein Eingriff der Software notwendig ist. Eine Modifikation der CRC-Codierung hat also keine Auswirkung auf die Anwendungs-Software.

Im Norm CAN-Protokoll werden die Stuff-Bits innerhalb des CAN-Nachrichten (vgl. ISO 11898-1, Kap. 10.5) nicht in die Berechnung oder Prüfung des CRC-Codes miteinbezogen (vgl. ISO 11898-1, Kap. 10.4.2.6: "... the bit stream given by the destuffed bit sequence ..."). Das hat zur Folge, dass in seltenen Fällen zwei Bit-Errors in einer Nachricht nicht erkannt werden, obwohl der CRC eigentlich bis zu fünf zufällig verteilte Bit-Errors in einer Nachricht erkennen sollte. Dies kann vorkommen, wenn sich durch die Bit-Fehler Stuff-Bits in DatenBits verwandeln, und umgekehrt (vgl. Unruh, Mathony und Kaiser: "Error Detection Analysis of Automotive Communication Protocols", SAE International Congress, Nr. 900699, Detroit, USA, 1990).

Im erfindungsgemäß modifizierten Übertragungsverfahren kann die CRC-Codierung demgegenüber so geändert werden, dass auch die Stuff-Bits innerhalb der Nachricht bei der Berechnung oder Prüfung des CRC-Codes miteinbezogen werden. Das heißt, es werden in dieser Ausführungsform die zum Arbitration Field, Control Field und Data Field gehörenden Stuff-Bits als Teil der durch den Cyclic Redundancy Check zu schützenden Daten behandelt. Die Stuff-Bits des CRC-Fields werden wie im Norm CAN ausgeblendet.

In einer möglichen Ausführungsform wird der Kommunikationscontroller so ausgelegt, dass er Kompatibilität zum Norm CAN aufweist, also in einem Norm CAN Bussystem normgemäß arbeitet, während er in einem erfindungsgemäß modifizierten Bussystem einerseits größere Datenfelder in den Nachrichten zulässt und andererseits auch die angepasste Berechnung und Prüfung des CRC-Code durchführt.

Da am Anfang des Empfanges einer Nachricht noch nicht feststeht, ob eine Norm-konforme CAN-Nachricht oder eine erfindungsgemäß modifizierte Nachricht empfangen wird, werden in einem erfindungsgemäßen Kommunikationscontroller zwei CRC-Schieberegister implementiert, die parallel arbeiten. Nach dem Empfang des CRC Delimiter, wenn der CRC-Code im Empfänger ausgewertet wird, steht aufgrund der erfindungsgemäßen dritten Kennzeichnung K3 beziehungsweise der beispielsweise aus der Kennzeichnung oder dem Inhalt des Data Length Code abgeleiteten dritten Umschaltbedingung UB3 auch fest, welches Übertragungsverfahren angewendet wurde, und es wird dann das diesem Übertragungsverfahren zugeordnete Schieberegister ausgewertet. Die dritte Umschaltbedingung UB3 kann, wie früher bereits dargestellt, mit der ersten Umschaltbedingung UB1, die die Größe des Datenfeldes und die Interpretation des Data Length Code betrifft, übereinstimmen.

Am Anfang des Sendens einer Nachricht steht zwar für den Sender bereits fest, nach welchem Übertragungsverfahren gesendet werden soll. Da es jedoch vorkommen kann, dass die Arbitration um den Buszugriff verloren wird und die begonnene Nachricht nicht gesendet, sondern stattdessen eine andere Nachricht empfangen wird, werden auch hier beide CRC-Schieberegister parallel angesteuert.

Die beschriebene Implementation zweier parallel arbeitender CRC-Schieberegister ermöglicht auch eine weitere Verbesserung:
Das CRC-Polynom des Norm CAN-Protokolls (x15 + x14 + x10 + x8 + x7 + x4 + x3 + 1) ist für eine Nachrichten-Länge von weniger als 127 Bits ausgelegt. Wenn erfindungsgemäß übertragene Nachrichten auch längere Datenfelder verwenden, ist es sinnvoll, zur Aufrechterhaltung der Übertragungssicherheit ein anderes, insbesondere längeres CRC-Polynom zu verwenden. Die erfindungsgemäß übermittelten Nachrichten erhalten dementsprechend ein geändertes, insbesondere längeres CRC Field. Im laufenden Betrieb wechseln die Kommunikationscontroller dynamisch zwischen den beiden CRC-Schieberegistern, also dem Norm CAN-gemäßen und dem erfindungsgemäßen Schieberegister, um das jeweils passende Polynom zu verwenden.

Natürlich können auch mehr als zwei Schieberegister und dementsprechend mehr als zwei CRC-Polynome abgestuft in Abhängigkeit von der Länge des Datenfeldes oder der gewünschten Übertragungssicherheit zum Einsatz kommen. In diesem Fall muss, sofern eine Kompatibilität zum Norm CAN erhalten bleiben soll, die entsprechende Kennzeichnung und die damit verbundene Umschaltbedingung angepasst werden. Beispielsweise könnte durch das reservierte Bit r0 oder das SRR-Bit in Figur 1b eine erste Umschaltbedingung UB1 ausgelöst werden, welche ein Umschalten auf längere Datenfelder, beispielsweise gemäß DLC 1 auf Figur 2, und ein zugehöriges zweites CRC-Polynom kennzeichnet. Für Nachrichten im Extended Format könnte zusätzlich, etwa gekennzeichnet durch das reservierte Bit r1 oder das IDE-Bit in Figur 1b (zweite Kennzeichnung K2), eine zweite Umschaltbedingung UB2 ausgelöst werden, welche die Umschaltung auf einen weiteren Satz von Datenfeldgrößen, beispielsweise DLC 3 aus Figur 2, und ein drittes CRC-Polynom kennzeichnet.

Es ist im übrigen auch möglich, dass die erste Umschaltbedingung UB1, etwa durch das reservierte Bit r0 oder das SRR-Bit, auf die Möglichkeit längerer Datenfelder und die entsprechende Interpretation des Inhaltes des Data Length Code umschaltet, und dass Ermittlung der dritten Umschaltbedingung UB3 und damit einhergehend die Auswahl des für die CRC-Prüfung auszuwertenden CRC-Polynoms dann abhängig vom Inhalt des Data Length Code erfolgt. Die dritte Umschaltbedingung UB3 kann dementsprechend auch mehr als zwei Werte annehmen. Beispielsweise könnten die Datenfeldgrößen gemäß DLC 3 ausgewählt werden, also die Werte 0 (für Remote-Frames) 1, ..., 8, 10, 12, 14, 16, 18, 20 und 24 Byte annehmen, und es könnten dann drei CRC-Polynome parallel über geeignete Schieberegister gerechnet werden, zum Beispiel das Norm CRC-Polynom für Datenfelder bis zu 8 Byte, ein zweites CRC-Polynom für Datenfelder bis zu 16 Byte und ein drittes CRC-Polynom für Datenfelder bis zu 24 Byte.

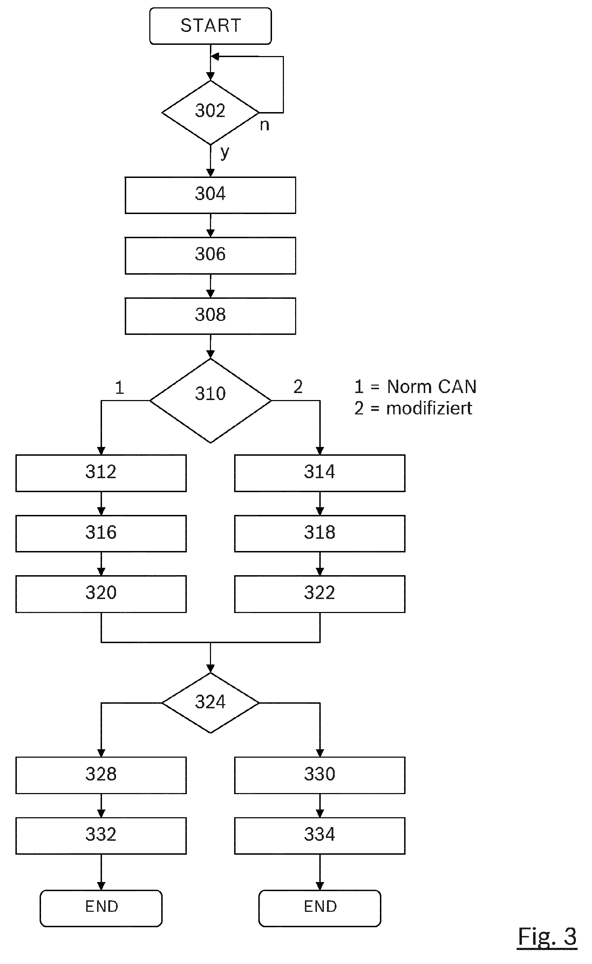

Figur 3 zeigt in vereinfachter Darstellung einen Ausschnitt des
erfindungsgemäßen Empfangsprozesses, wie er auf einer Teilnehmerstation des Bussystems abläuft. Dargestellt ist hier der Fall, bei welchem eine Kompatibilität zum Norm CAN erreicht wird, indem abhängig von der ersten Umschaltbedingung UB1 das Verhalten des Kommunikationscontrollers angepasst wird. Obwohl in Figur 3 eine für die Beschreibung von Programmabläufen in Software übliche Darstellung gewählt wurde, ist das Verfahren gleichermaßen vollständig zur Implementierung in Hardware geeignet.

Die Teilnehmerstation befindet sich zunächst in einem den Bus abtastenden Zustand, so lange auf dem Bus kein Kommunikationsverkehr herrscht. Die Abfrage 302 wartet also auf ein dominantes Bit auf dem Bus. Dieses Bit kennzeichnet den Beginn einer neuen Nachricht.

Sobald der Beginn einer neuen Nachricht festgestellt wurde beginnt im Block 304 die Berechnung der wenigstens zwei parallel zu berechnenden Checksummen. Die erste Checksumme entspricht der CRC Berechnung des Norm CAN, während die zweite Checksumme nach dem neuen Verfahren berechnet wird. Bei der Berechnung der zweiten Checksumme werden im dargestellten Ausführungsbeispiel die Stuff-Bits miteinbezogen, während dies bei der Berechnung gemäß Norm CAN nicht der Fall ist. Es ist aber auch möglich, analog zum Norm CAN die Stuff-Bits auch für die Berechnung der zweiten Checksumme nicht zu berücksichtigen.

Es werden anschließend ab dem Schritt 306 die weiteren, auf das SOF-Bit folgenden Bits der Nachricht, beginnend mit dem Arbitration Field, empfangen. Falls mehrere Busteilnehmer eine Nachricht versenden wollen, wird hierbei nach dem aus dem Norm CAN üblichen Verfahren unter den Busteilnehmern ausgehandelt, welcher Busteilnehmer den Zugriff auf den Bus erhält. Der dargestellte Block 306 kennzeichnet den Empfang aller Bits, bis die erste Kennzeichnung K1 empfangen wurde beziehungsweise die erste Umschaltbedingung UB1 feststeht. In den aufgeführten Beispielen wird die erste Umschaltbedingung UB1 aus dem Arbitration Field, beispielsweise aus dem SRR-Bit oder dem IDE-Bit, oder aus dem Control Field, beispielsweise aus einem reservierten Bit desselben, ermittelt (vgl. Figur 1). Anschließend können in Block 308 noch weitere Bits der Nachricht empfangen werden, bis ab einem bestimmten Bit der Nachricht abhängig von der ermittelten ersten Umschaltbedingung UB1 unterschiedlich verfahren wird. Diese Aufspaltung in unterschiedliche Verfahrensweisen wird durch eine entsprechende Abfrage oder Verzweigung 310 gewährleistet, wie im Folgenden beispielhaft dargestellt.

Liegt bei der Verzweigung 310, beispielsweise nach Empfang der ersten zwei Bits des Control Field, die Information vor, dass gemäß der ersten Umschaltbedingung UB1 die Kommunikation nach Norm CAN erfolgt (der mit "1" bezeichnete Pfad der Figur 3), so werden im Schritt 312 die weiteren Bits des Control Field eingelesen. Aus diesen Bits wird gemäß Norm CAN der Data Length Code ausgewertet und es wird anschließend in Schritt 316 die zugehörige Menge an Daten, maximal 8 Byte, entsprechend dem Datenfeld, empfangen. Im Schritt 320 wird dann das 15 Bit umfassende CRC Feld empfangen. Liegt bei der Verzweigung 324 die Information vor, dass die die vom Sender übermittelte und die vom Empfänger selbst ermittelte CRC Checksumme übereinstimmen, wird in Block 328 ein dominantes Acknowledge-Bit gesendet. Es ist zu beachten, dass in diesem Fall die normgemäße CRC Checksumme verglichen wird, da die Kommunikation nach Norm CAN erfolgt. Wird keine Übereinstimmung festgestellt, wird (Block 330) das Acknowledge-Bit rezessiv gesendet. Anschließend folgen ACK Delimiter und EOF Bits (siehe Figur 1b, in Figur 3 nicht dargestellt).

Liegt hingegen bei der Verzweigung 310, beispielsweise nach Empfang der ersten zwei Bits des Control Field, die Information vor, dass gemäß der ersten Umschaltbedingung UB1 das erfindungsgemäß modifizierte Kommunikationsverfahren anzuwenden ist (der mit "2" bezeichnete Pfad der Figur 3), so werden im Block 314 die weiteren Bits des Control Field eingelesen. Aus dem Ergebnis wird der Data Length Code nach der neuen Interpretation, für die einige Beispiele tabellenartig in Figur 2 aufgeführt sind, ermittelt. Im Block 318 wird die entsprechende Menge an Daten, also für das Beispiel DLC 1 aus der Tabelle in Figur 2 bis zu 15 Byte, für das Beispiel DLC 2 bis zu 16 Byte, für das Beispiel DLC 3 bis zu 24 Byte und für das Beispiel DLC 4 bis zu 30 Byte Daten empfangen. Im Block 322 wird das erfindungsgemäß abweichende, insbesondere längere CRC Feld empfangen. Liegt bei der Verzweigung 324 die Information vor, dass die vom Sender übermittelte und die vom Empfänger selbst ermittelte CRC Checksumme übereinstimmen, wobei in diesem Fall der Vergleich auf der erfindungsgemäß abweichenden CRC Checksumme basiert, wird in Block 328 ein dominantes Acknowledge-Bit gesendet. Andernfalls wird (Block 330) das Acknowledge-Bit rezessiv gesendet. Anschließend folgen in Schritt 332 beziehungsweise 334 der ACK Delimiter und die EOF Bits. Damit ist ein Empfangsprozess für eine Nachricht beendet.

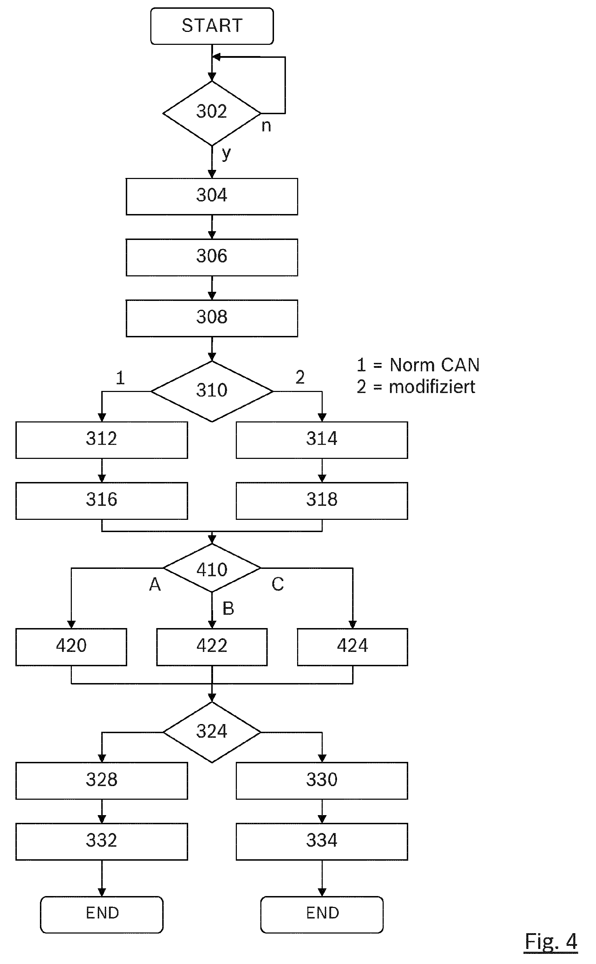

In Figur 3 wurde der Fall dargestellt, in welchem die dritte Umschaltbedingung UB3, welche die zu verwendende CRC bestimmt, mit der ersten Umschaltbedingung UB1, die die Größe des Datenfeldes und die Interpretation des Data Length Code betrifft, übereinstimmt. Es wurde also vor dem Empfang 320 beziehungsweise 322 der CRC Checksummen nicht nochmals abgefragt, welche CRC gemäß der dritten Umschaltbedingung UB3 zu empfangen und für die Verzweigung 324 auszuwerten ist. Durch eine einfache Modifikation des Ablaufdiagrammes aus Figur 3 ist diese zusätzliche Abfrage in den Ablauf aufnehmbar, wie in Figur 4 dargestellt ist.

Bei dem derartig modifizierten Empfangsprozess gemäß Figur 4 wird nach Empfang der gemäß der Information aus dem Data Length Code erwarteten Anzahl von Datenbytes des Datenfeldes in Block 316 beziehungsweise 318 in der Abfrage oder Verzweigung 410 ermittelt, welchen Wert die dritte Umschaltbedingung UB3 aufweist. Diese Information kann, wie früher beschrieben, beispielsweise aus der entsprechenden dritten Kennzeichnung K3, oder aus dem Inhalt des Data Length Code ermittelt worden sein. Im dargestellten Beispiel gibt es drei verschiedene Werte für die dritte Umschaltbedingung UB3, nämlich A, B und C. Abhängig vom Wert der Umschaltbedingung UB3 wird dann in den Blöcken 420, 422 und 424 eine unterschiedliche Anzahl von Bits des CRC Field eingelesen, beispielsweise für den Wert A 15 Bits, für den Wert B 17 Bits und für den Wert C 19 Bits. Anschließend wird bei der Verzweigung 324 analog zu Figur 3 geprüft, ob die vom Sender übermittelte und die vom Empfänger selbst ermittelte CRC Checksumme übereinstimmen und abhängig davon weiter verfahren.

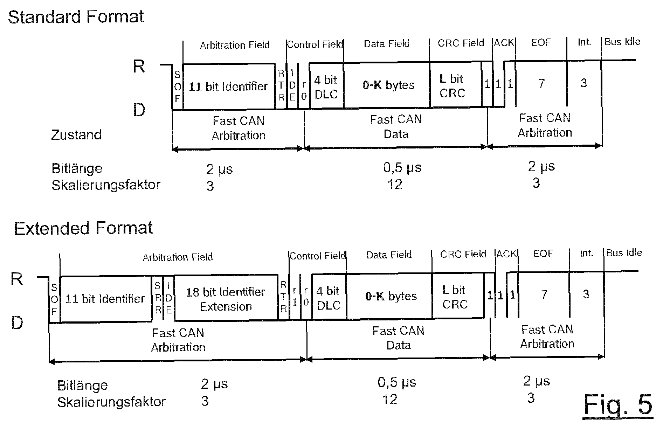

Figur 5 zeigt für weitere Ausführungsbeispiele des erfindungsgemäßen Übertragungsverfahrens nochmals die Struktur von Nachrichten in den zwei möglichen Varianten, dem Standard Format und dem Extended Format. Für beide Varianten sind in Figur 5 Bereiche eingezeichnet, in denen zwischen zwei Zuständen, hier bezeichnet mit Fast-CAN-Arbitration und Fast-CAN-Data umgeschaltet wird. Diese Umschaltung zwischen den beiden Zuständen bewirkt in diesem Beispiel, dass nach Abschluss der Arbitrierung für einen Teil der Nachricht, insbesondere für das Datenfeld und das CRC Feld, die Bitlängen verkürzt und somit die einzelnen Bits schneller über den Bus übertragen werden. Dadurch kann die Übertragungszeit für eine Nachricht gegenüber dem normgemäßen Verfahren verkürzt werden. Der zugehörige Wechsel der zeitlichen Bitlänge kann beispielsweise durch Verwendung mindestens zweier unterschiedlicher Skalierungsfaktoren zur Einstellung der Bus-Zeiteinheit relativ zu einer kleinsten Zeiteinheit oder dem Oszillatortakt im laufenden Betrieb realisiert werden. Die Umschaltung der Bitlänge, sowie die entsprechende Veränderung des Skalierungsfaktors sind in Figur 5 ebenfalls beispielhaft dargestellt.

Der Übergang zwischen den Zuständen Fast-CAN-Arbitration und Fast-CAN-Data kann abhängig von einer vierten Umschaltbedingung UB4 erfolgen, welche mit einer vierten Kennzeichnung K4 der Nachrichten korrespondiert, die den Teilnehmern der Datenübertragung signalisiert, dass die verkürzte Bitlänge angewendet wird. In dem hier dargestellten Ausführungsbeispiel ist die gewählte Position dieser Kennzeichnung K4 das "reserved bit" r0, das vor dem Data Length Code übertragen wird. Sie entspricht also einer möglichen Position der ersten Kennzeichnung K1, welche zur ersten Umschaltbedingung UB1 korrespondiert und die mögliche Verwendung längerer Datenfelder und einer geänderten Interpretation des Data Length Code kennzeichnet, und auch der dritten Kennzeichnung K3, welche zu einer geänderten CRC Berechnung korrespondiert.

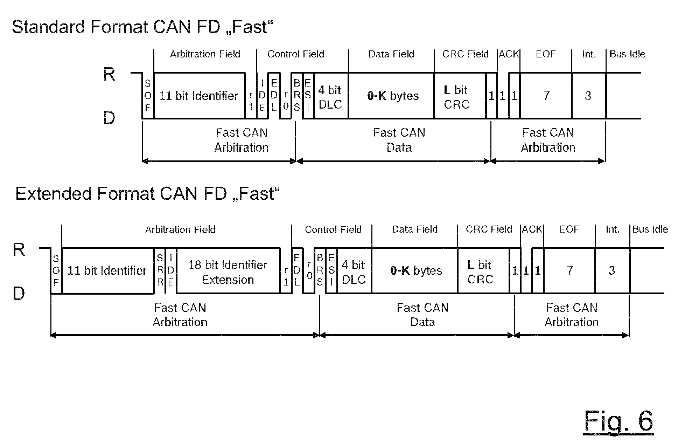

Eine andere Möglichkeit zur Kennzeichnung der erfindungsgemäßen Nachrichten mit verkürzter Bitlänge ist in Figur 6 dargestellt. Hier sind die Nachrichten mit potenziell längeren Datenfeldern (zugehörig: erste Kennzeichnung K1) und geänderter CRC-Berechung (zugehörig: dritte Kennzeichnung K3) durch ein rezessives EDL-Bit (Extended Data Length) gekennzeichnet, welches an die Stelle eines in Norm CAN Nachrichten dominant übertragenen Bits tritt und dieses Bit ersetzt oder um eine Position nach hinten verschiebt. Für die Standard-Adressierung tritt das EDL-Bit an die zweite Position im Control Field und verschiebt das dort befindliche, stets dominante r0-Bit um eine Position. Für die Extended Adressierung tritt das EDL-Bit im gezeigten Beispiel an die erste Position des Control Field und ersetzt das dort befindliche reservierte r1-Bit, das im Norm-CAN stets dominant übertragen wird. Die vierte Kennzeichnung K4, die die Verwendung der verkürzten Bitlänge ankündigt, ist durch das Einfügen eines zusätzlichen, rezessiven BRS-Bits (Bit Rate Switch) in das Control Field von erfindungsgemäßen Nachrichten, welche durch das EDL-Bit gekennzeichnet sind, dargestellt. In dem hier dargestellten Ausführungsbeispiel ist die Position des BRS-Bits die vierte (Standard Adressierung) bzw. dritte (Extended Adressierung) Position im Control Field.

Die Nachrichten tragen die Bezeichnung "CAN FD Fast". Für die zwei möglichen Adressierungsvarianten von Nachrichten, das Standard Format und das Extended Format, sind in Figur 6 Bereiche eingezeichnet, in denen zwischen zwei Zuständen, bezeichnet mit Fast-CAN-Arbitration und Fast-CAN-Data umgeschaltet wird. Diese Umschaltung zwischen den beiden Zuständen bewirkt, wie bereits geschildert, dass für den entsprechenden Teil der Nachricht die Bitlängen verkürzt und somit die einzelnen Bits schneller über den Bus übertragen werden. Dadurch kann die Übertragungszeit für eine Nachricht gegenüber dem normgemäßen Verfahren verkürzt werden. Der Übergang zwischen den Zuständen Fast-CAN-Arbitration und Fast-CAN-Data erfolgt in Nachrichten, welche die erste bzw. dritte Kennzeichnung EDL aufweisen, abhängig von der vierten Kennzeichnung BRS, die den Teilnehmern der Datenübertragung signalisiert, dass die verkürzte Bitlänge angewendet wird

In dem dargestellten Fall, in dem also auf die erste Kennzeichnung EDL die zweite Kennzeichnung BRS folgt, werden im erfindungsgemäßen Übertragungsverfahren Nachrichten übertragen, deren Bitlänge deutlich verkürzt, deren Datenfeldgröße auf Werte oberhalb 8 Byte ausdehnbar, und deren CRC an das größere Datenfeld angepasst ist. Erhebliche Steigerung der Übertragungskapazität über das Bussystem bei gleichzeitig verbesserter Übertragungssicherheit werden so erreicht.

Die schnellere Übertragung beginnt im dargestellten Beispiel unmittelbar nach Versenden der zugehörigen Kennzeichnung und wird unmittelbar nach Erreichen des für die Rückumschaltung festgelegten Bits beendet oder dann, wenn ein Grund zum Start eines Error-Frames erkannt wurde.

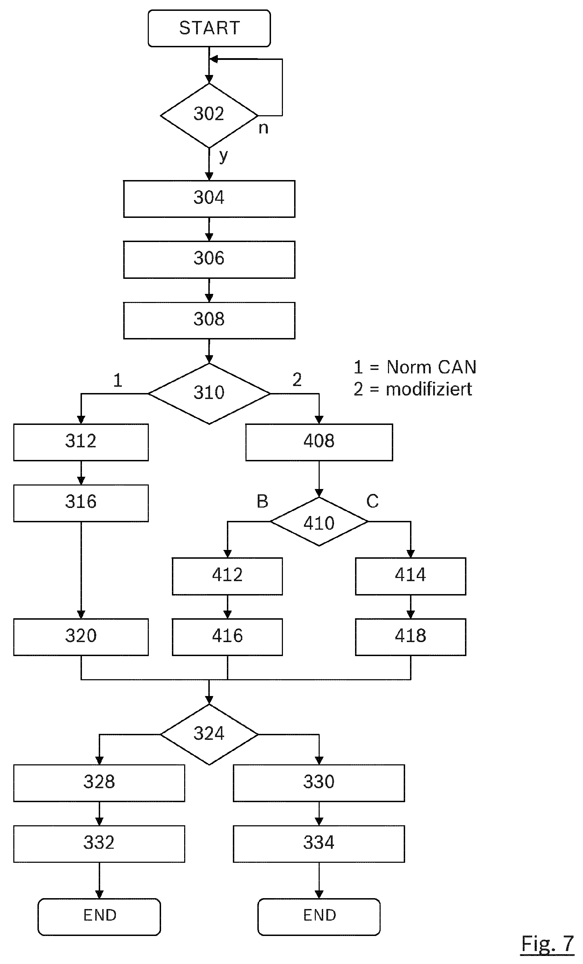

Figur 7 zeigt einen gegenüber Figur 3 modifizierten Empfangsprozess, bei welchem zusätzlich abhängig von der zweiten Kennzeichnung BRS zwischen den Zuständen Fast-CAN-Arbitration und Fast-CAN-Data umgeschaltet wird. Liegt bei der Verzweigung 310, beispielsweise nach Empfang des zweiten Bits des Control Field als rezessivem Bit EDL, die Information vor, dass das erfindungsgemäß modifizierte Kommunikationsverfahren anzuwenden ist, so werden im Block 408 die nächsten Bits des Control Field eingelesen. Wird das zur zweiten Kennzeichnung dienende Bit, beispielsweise das vierte Bit BRS des erfindungsgemäß erweiterten Control Field, mit dem vorgesehenen Wert, beispielsweise rezessiv, empfangen, so wird beispielsweise am Sample Point dieses Bits der Zustand Fast-CAN-Data eingenommen, also auf die verkürzte Bitlänge umgeschalten (Pfad "C"). Weist das betreffende Bit den umgekehrten Wert auf, also in diesem Beispiel dominant, so erfolgt keine Verkürzung der Bitlänge (Pfad "B"). In den Blöcken 412 beziehungsweise 414 erfolgt der Empfang der verbleibenden Bits des Control Field inklusive des Data Length Code und der Empfang des Datenfeldes gemäß der Größeninformation aus dem Data Length Code. Im Block 412 wird mit normaler Bitlänge empfangen, im Block 414 mit der verkürzten Bitlänge. In den Blöcken 416 beziehungsweise 418 wird das erfindungsgemäß abweichende, insbesondere längere CRC Field eingelesen. Am letzten Bit des CRC Field, dem CRC Delimiter wird im Block 418 wieder in den Zustand Fast-CAN-Arbitration mit gewöhnlicher Bitrate umgeschalten. Anschließend wird bei der Verzweigung 324 analog zu Figur 3 geprüft, ob die vom Sender übermittelte und die vom Empfänger selbst ermittelte CRC Checksumme übereinstimmen und es wird abhängig davon weiter verfahren, wie schon in Figur 3.

Den Nutzen des in Figur 5 dargestellten Ausführungsbeispiels in Kombination mit dem mit DLC 3 bezeichneten Ausführungsbeispiel des Verfahrens mit geänderter Größe des Datenfeldes hinsichtlich der erzielten Datenübertragungsrate veranschaulicht die folgende Rechnung: Es wird von einer Länge des Datenfeldes von 24 Byte, von Datenrahmen im Standard Format mit 11 Bit Adressierung, sowie von einer Baudrate von 500 kBit/s ausgegangen. Des weiteren wird angenommen, dass der Skalierungsfaktor nach dem "reserved bit" r0 um einen Faktor vier erhöht wird. In diesem Fall würde die Bitlänge also nach dem "reserved bit" r0 von 2 Mikrosekunden auf 0,5 Mikrosekunden reduziert. Es werden bei Vernachlässigung von möglichen Stuff-Bits in diesem Beispiel pro Datenrahmen 27 Bit (SOF, Identifier, RTR, IDE, r0, ACK-Field, EOF, Intermission) mit der normalen Bitlänge und 212 Bit (DLC, Data, CRC, CRCDelimiter) mit der verkürzten Bitlänge übertragen, wobei hier noch von einer 15-Bit CRC ausgegangen wurde, welche aber erfindungsgemäß durch eine längere CRC ersetzt werden könnte.

Es ergibt sich unter den gegebenen Randbedingungen eine effektive Übertragungsleistung von 293 Bit in 160 Mikrosekunden, was bei gleicher angenommener Busauslastung einer Datenübertragungsrate entspricht, die gegenüber der nicht modifizierten Norm CAN-Übertragung um einen Faktor 3,7 erhöht ist. Zusätzlich verschiebt sich das Verhältnis von Nutzdaten (Data Field) zu Protokoll-Overhead in vorteilhafter Weise.

Das Verfahren eignet sich im normalen Betrieb eines Kraftfahrzeuges zur Übertragung von Daten zwischen wenigstens zwei Steuergeräten des Kraftfahrzeuges, welche über einen geeigneten Datenbus verbunden sind. Es ist aber gleichermaßen vorteilhaft einsetzbar während der Fertigung oder Wartung eines Kraftfahrzeuges zur Übertragung von Daten zwischen einer zum Zwecke der Programmierung mit einem geeigneten Datenbus verbundenen Programmierungseinheit und wenigstens einem Steuergerät des Kraftfahrzeuges, welches mit dem Datenbus verbunden ist.
Weiterhin ist es auch möglich, das Verfahren in der industriellen Automatisierung einzusetzen, also beispielsweise zur Übertragung von Steuerinformation zwischen verteilten, durch den Bus miteinander verbundenen Steuereinheiten, die den Ablauf eines industriellen Fertigungsablaufes steuern. In diesem Umfeld können auch sehr lange Busleitungen auftreten und es kann besonders sinnvoll sein, das Bussystem für die Arbitirierungsphase mit einer relativ langen Bitlänge zu betreiben, beispielsweise mit 16, 32 oder 64 Mikrosekunden, so dass die Bussignale sich während des Arbitirierungsvorganges wie erforderlich auf dem gesamten Bussystem ausbreiten können. Anschließend kann dann für einen Teil der Nachricht, wie beschrieben, auf kürzere Bitlängen umgeschalten werden, um die mittlere Übertragungsrate nicht zu klein werden zu lassen.

Insgesamt stellt das Verfahren ein Übertragungsverfahren dar, welches sich dadurch auszeichnet, dass ein Norm-CAN Controller nur minimal geändert werden muss, um erfindungsgemäß arbeiten zu können. Ein erfindungsgemäßer Kommunikationscontroller, der auch als Norm-CAN Controller arbeiten kann, ist nur unwesentlich größer als ein herkömmlicher Norm-CAN Controller. Das zugehörige Anwendungs-Programm muss nicht geändert werden, und schon dann werden Vorteile in der Geschwindigkeit der Datenübertragung erzielt. Durch Verwendung der erweiterten Größe des Datenfeldes und der zugehörigen DLC und CRC kann die Geschwindigkeit der Datenübertragung weiter gesteigert werden, die Anpassungen in der Anwendungs-Software sind minimal. Es können weite Teile des CAN-Conformance-Tests (ISO 16845) übernommen werden. Es ist auch möglich, das erfindungsgemäße Übertragungsverfahren mit den Ergänzungen des TTCAN (ISO 11898-4) zu kombinieren.

Wo in der vorangegangenen Beschreibung der Erfindung auf ISO-Standards Bezug genommen wurde, ist jeweils die zum Anmeldezeitpunkt geltende Fassung des entsprechenden ISO-Standards als Stand der Technik zugrundezulegen.

## Patentansprüche

1. Verfahren zur seriellen Datenübertragung in einem Bussystem mit mindestens zwei teilnehmenden Datenverarbeitungseinheiten, die über den Bus Nachrichten austauschen,
wobei die gesendeten Nachrichten einen logischen Aufbau gemäß der CAN-Norm ISO 11898-1 aufweisen,
wobei der logische Aufbau ein Start-of-Frame-Bit, ein Arbitration Field, ein Control Field, ein Data Field, ein CRC Field, ein Acknowledge Field und eine End-of-Frame Sequenz umfasst,
wobei das Control Field einen Data Length Code umfasst, der eine Information über die Länge des Data Fields enthält,
**dadurch gekennzeichnet, dass** in Abhängigkeit vom Wert einer zugeordneten Umschaltbedingung (UB3) das CRC Field der Nachrichten wenigstens zwei unterschiedliche Anzahlen von Bits aufweisen kann,
wobei zu Beginn einer Nachricht die Berechnung von wenigstens zwei CRC Checksummen mittels unterschiedlicher Generator-Polynome parallel gestartet wird.

2. Verfahren nach Anspruch 1,
**dadurch gekennzeichnet, dass** zur Festlegung des Inhaltes des CRC Field in Abhängigkeit vom Wert der zugeordneten Umschaltbedingung (UB3) wenigstens zwei unterschiedliche Generator-Polynome verwendet werden.

3. Verfahren nach Anspruch 1 oder 2,
**dadurch gekennzeichnet, dass** für wenigstens einen Wert der zugeordneten Umschaltbedingung (UB3) die Anzahl von Bits im CRC Field und das zur Festlegung des Inhaltes des CRC Field verwendete Generator-Polynom der CAN-Norm ISO 11898-1 entsprechen.

4. Verfahren nach einem der Ansprüche 1 bis 3,
**dadurch gekennzeichnet, dass** die Nachrichten, in denen in Abhängigkeit vom Wert einer zugeordneten Umschaltbedingung (UB3) das CRC Field der Nachrichten wenigstens zwei unterschiedliche Anzahlen von Bits aufweisen kann, durch eine geeignete Kennzeichnung (K1, K3) im Arbitration Field und/oder im Control Field erkennbar sind.

5. Verfahren nach einem der Ansprüche 1 bis 4,
**dadurch gekennzeichnet, dass** der Wert der zugeordneten Umschaltbedingung (UB3) in den teilnehmenden Datenverarbeitungseinheiten in Abhängigkeit von der geeigneten Kennzeichnung (K1, K3) ermittelt wird oder in Verbindung mit dem Inhalt des Data Length Code abgeleitet wird, wobei abhängig vom Wert der zugeordneten Umschaltbedingung (UB3) der Empfangsprozess an die Größe des CRC Field angepasst wird

6. Verfahren nach einem der Ansprüche 1 bis 5,
**dadurch gekennzeichnet, dass** abhängig vom Wert der zugeordneten Umschaltbedingung (UB3) entschieden wird, welches Ergebnis aus einer der parallel gestarteten CRC-Berechnungen verwendet wird.

7. Verfahren nach einem der Ansprüche 1 bis 6,
**dadurch gekennzeichnet, dass** bei Vorliegen der zugeordneten Umschaltbedingung (UB3) bei wenigstens einer der parallel ausgeführten CRC-Berechnungen auch eventuelle Stuff-Bits innerhalb der Abschnitte der Nachricht, die vor dem CRC Field liegen, berücksichtigt werden.

8. Verfahren nach einem der Ansprüche 1 bis 7,
**dadurch gekennzeichnet, dass** bei Vorliegen einer weiteren Umschaltbedingung (UB1) das Datenfeld der Nachrichten abweichend von der CAN-Norm ISO 11898-1 mehr als acht Bytes umfassen kann,
wobei zur Feststellung der Größe des Datenfeldes bei Vorliegen der weiteren Umschaltbedingung (UB1) die Werte der vier Bits des Data Length Codes zumindest teilweise abweichend von der CAN-Norm ISO 11898-1 interpretiert werden.

9. Verfahren nach Anspruch 8,
**dadurch gekennzeichnet, dass** bei Vorliegen der weiteren Umschaltbedingung (UB1) jeder der möglichen Wertekombinationen der Bits des Data Length Code eine der zulässigen Größen des Datenfeldes zugeordnet sind.

10. Verfahren nach einem der Ansprüche 8 bis 9,
**dadurch gekennzeichnet, dass** die Nachrichten, in denen das Datenfeld der Nachrichten abweichend von der CAN-Norm ISO 11898-1 mehr als acht Bytes umfassen kann und zur Feststellung der Größe des Datenfeldes die Werte der vier Bits des Data Length Codes zumindest teilweise abweichend von der CAN-Norm ISO 11898-1 interpretiert werden, durch eine geeignete Kennzeichnung (K1) im Arbitration Field und/oder im Control Field von CAN-normgemäßen Nachrichten unterscheidbar sind.

11. Verfahren nach einem der Ansprüche 8 bis 10,
**dadurch gekennzeichnet, dass** die weitere Umschaltbedingung (UB1) aus der zugeordneten Umschaltbedingung (UB3) abgeleitet wird oder mit ihr übereinstimmt.

12. Verfahren nach einem der Ansprüche 8 bis 11,
**dadurch gekennzeichnet, dass** die geeignete Kennzeichnung (K1) in den teilnehmenden Datenverarbeitungseinheiten zur Ermittlung der weiteren Umschaltbedingung (UB1) ausgewertet wird und abhängig von der weiteren Umschaltbedingung (UB1) der Empfangsprozess an die Größe des Datenfeldes angepasst wird.

13. Verfahren nach einem der Ansprüche 8 bis 12,
**dadurch gekennzeichnet, dass** die Werte zwischen 0b0001 und 0b1000 des Data Length Codes für die Größen des Datenfeldes zwischen 1 und 8 Bytes gemäß der CAN-Norm ISO 11898-1 genutzt werden und bei Vorliegen der weiteren Umschaltbedingung (UB1) die restlichen Werte des Data Length Code für die weiteren zulässigen Größen des Datenfeldes bis zur maximal möglichen Größe genutzt werden.

14. Verfahren nach einem der Ansprüche 8 bis 13,
**dadurch gekennzeichnet, dass** bei Vorliegen einer zusätzlichen Umschaltbedingung (UB2) die vier Bits des Data Length Codes zumindest teilweise abweichend von der CAN-Norm ISO 11898-1 und abweichend von der Zuordnung, wenn die zusätzliche Umschaltbedingung nicht vorliegt, interpretiert werden.

15. Verfahren nach Anspruch 14,
**dadurch gekennzeichnet, dass** die Nachrichten, in denen bei Vorliegen einer zusätzlichen Umschaltbedingung (UB2) die vier Bits des Data Length Codes zumindest teilweise abweichend von der CAN-Norm ISO 11898-1 und abweichend von der Zuordnung, wenn die zusätzliche Umschaltbedingung nicht vorliegt, interpretiert werden sollen, durch eine zusätzliche Kennzeichnung (K2) im Arbitration Field und/oder im Control Field erkennbar sind.

16. Verfahren nach einem der Ansprüche 1 bis 15,
**dadurch gekennzeichnet, dass** in Abhängigkeit vom Wert einer vierten Umschaltbedingung (UB4) die zeitliche Bitlänge innerhalb einer Nachricht mindestens zwei unterschiedliche Werte annehmen kann, wobei für wenigstens einen ersten vorgebbaren Bereich innerhalb der Nachricht die zeitliche Bitlänge größer oder gleich einem vorgegebenen Minimalwert von etwa einer Mikrosekunde ist und in mindestens einem zweiten vorgebbaren Bereich innerhalb der Nachricht die zeitliche Bitlänge eine im Vergleich zum ersten Bereich reduzierten Wert aufweist.

17. Verfahren nach Anspruch 16,
**dadurch gekennzeichnet, dass** die mindestens zwei unterschiedlichen Werte der zeitlichen Bitlänge innerhalb einer Nachricht durch Verwendung mindestens zweier unterschiedlicher Skalierungsfaktoren zur Einstellung der Bus-Zeiteinheit relativ zu einer kleinsten Zeiteinheit oder dem Oszillatortakt im laufenden Betrieb realisiert werden.

18. Verfahren nach einem der Ansprüche 16 oder 17,
**dadurch gekennzeichnet, dass** die Nachrichten, in denen in Abhängigkeit vom Wert einer vierten Umschaltbedingung (UB4) die zeitliche Bitlänge innerhalb einer Nachricht mindestens zwei unterschiedliche Werte annehmen kann, durch eine vierte Kennzeichnung (K4) im Arbitration Field und / oder im Control Field erkennbar sind, wobei die vierte Kennzeichnung mit der ersten und / oder dritten Kennzeichnung (K1, K3) übereinstimmen kann..

19. Verfahren nach einem der Ansprüche 16 bis 18,
**dadurch gekennzeichnet, dass** der Wert der vierten Umschaltbedingung (UB4) in den teilnehmenden Datenverarbeitungseinheiten in Abhängigkeit von der vierten Kennzeichnung (K4) ermittelt wird oder mit der weiteren Umschaltbedingung (UB1) und / oder der zugeordneten Umschaltbedingung (UB3) übereinstimmt oder aus der weiteren Umschaltbedingung (UB1) und / oder der zugeordneten Umschaltbedingung (UB3) abgeleitet wird, wobei abhängig vom Wert der vierten Umschaltbedingung der Empfangsprozess an die unterschiedlichen Werte der Bitlänge innerhalb einer Nachricht angepasst wird.

20. Verfahren nach einem der Ansprüche 2 bis 19,
**dadurch gekennzeichnet, dass**
wenigstens eine der geeigneten Kennzeichnungen (K1, K3) durch ein erstes Kennzeichen-Bit (EDL) erfolgt, dessen Position zwischen dem letzten Bit des Identifiers und dem ersten Bit des Data Length Code liegt und an dessen Position sich in Nachrichten gemäß der CAN-Norm ISO 11898-1 ein Bit mit einem festgelegten Wert befindet.

21. Verfahren nach einem der Ansprüche 15 bis 20,
**dadurch gekennzeichnet, dass** die zusätzliche Kennzeichnung (K2) durch ein zweites Kennzeichen-Bit erfolgt, welches zwischen dem ersten Kennzeichen-Bit (EDL) und dem ersten Bit des Data Length Code liegt.

22. Verfahren nach einem der Ansprüche 18 bis 21,
**dadurch gekennzeichnet, dass** die vierte Kennzeichnung (K4) durch ein weiteres Kennzeichen-Bit (BRS) erfolgt, welches zwischen dem ersten Kennzeichen-Bit (EDL) und dem ersten Bit des Data Length Code liegt.

23. Verfahren nach einem der Ansprüche 1 bis 22,
**dadurch gekennzeichnet, dass** die Nachrichten zeitgesteuert gemäß dem in der TTCAN-Norm ISO 11898-4 beschriebenen Verfahren übertragen werden.

24. Vorrichtung zur seriellen Datenübertragung in einem Bussystem mit mindestens zwei teilnehmenden Datenverarbeitungseinheiten, die über den Bus
Nachrichten austauschen,
wobei die gesendeten Nachrichten einen logischen Aufbau gemäß der CAN-Norm ISO 11898-1 aufweisen,
wobei der logische Aufbau ein Start-of-Frame-Bit, ein Arbitration Field, ein Control Field, ein Data Field, ein CRC Field, ein Acknowledge Field und eine End-of-Frame Sequenz umfasst,
wobei das Control Field einen Data Length Code umfasst, der eine Information über die Länge des Data Fields enthält,
**dadurch gekennzeichnet, dass** zumindest in Abhängigkeit vom Wert einer zugeordneten Umschaltbedingung (UB3) das CRC Field der Nachrichten wenigstens zwei unterschiedliche Anzahlen von Bits aufweisen kann, wobei zu Beginn einer Nachricht die Berechnung von wenigstens zwei CRC Checksummen mittels unterschiedlicher Generator-Polynome parallel gestartet wird.

25. Vorrichtung nach Anspruch 24,
**dadurch gekennzeichnet, dass** die Vorrichtung durch geeignete Mittel dafür eingerichtet ist, zumindest eines der Verfahren zur Datenübertragung gemäß Anspruch 2 bis 23 auszuführen.

26. Vorrichtung nach Anspruch 25,
**dadurch gekennzeichnet, dass** die geeigneten Mittel eine zur Berechnung des Inhaltes des CRC Field durch die wenigstens zwei unterschiedlichen Generator-Polynome ausreichende Anzahl von Schieberegistern umfassen.

27. Verwendung des Verfahrens nach einem der Ansprüche 1 bis 23
im normalen Betrieb eines Kraftfahrzeuges oder einer industriellen Anlage zur Übertragung von Daten zwischen wenigstens zwei Steuergeräten des Kraftfahrzeuges oder der industriellen Anlage, welche über einen geeigneten Datenbus verbunden sind.

28. Verwendung des Verfahrens nach einem der Ansprüche 1 bis 23
während der Fertigung oder Wartung eines Kraftfahrzeuges oder einer industriellen Anlage zur Übertragung von Daten zwischen einer zum Zwecke der Programmierung mit einem geeigneten Datenbus verbundenen Programmierungseinheit und wenigstens einem Steuergerät des Kraftfahrzeuges oder der industriellen Anlage, welches mit dem Datenbus verbunden ist.

## Claims

1. Method for serially transmitting data in a bus system having at least two participating data processing units which interchange messages via the bus,
the transmitted messages having a logical structure according to the CAN standard ISO 11898-1,
the logical structure comprising a start-of-frame bit, an arbitration field, a control field, a data field, a CRC field, an acknowledge field and an end-of-frame sequence,
the control field comprising a data length code containing an item of information relating to the length of the data field,
**characterized in that** the CRC field of the messages may have at least two different numbers of bits depending on the value of an associated changeover condition (UB3),
wherein, at the beginning of a message, the calculation of at least two CRC checksums is started in a parallel manner using different generator polynomials.

2. Method according to Claim 1,
**characterized in that,** in order to determine the content of the CRC field, depending on the value of the associated changeover condition (UB3), at least two different generator polynomials are used.

3. Method according to Claim 1 or 2,
**characterized in that,** for at least one value of the associated changeover condition (UB3), number of bits in the CRC field and the generator polynomial used to determine the content of the CRC field correspond to the CAN standard ISO 11898-1.

4. Method according to one of Claims 1 to 3,
**characterized in that** the messages, in which the CRC field of the messages may have at least two different numbers of bits depending on the value of an associated changeover condition (UB3), can be identified by means of a suitable identification (K1, K3) in the arbitration field and/or in the control field.

5. Method according to one of Claims 1 to 4,
**characterized in that** the value of the associated changeover condition (UB3) is determined in the participating data processing units on the basis of the suitable identification (K1, K3) or is derived in conjunction with the content of the data length code, wherein the receiving process is adapted to the size of the CRC field depending on the value of the associated changeover condition (UB3).

6. Method according to one of Claims 1 to 5,
**characterized in that,** depending on the value of the associated changeover condition (UB3), a decision is made as to which result from one of the CRC calculations started in a parallel manner is used.

7. Method according to one of Claims 1 to 6,
**characterized in that,** if the associated changeover condition (UB3) is present, possible stuff bits inside those sections of the message which are in front of the CRC field are also taken into account in at least one of the CRC calculations that are carried out in a parallel manner.

8. Method according to one of Claims 1 to 7,
**characterized in that,** if a further changeover condition (UB1) is present, the data field of the messages may comprise more than eight bytes in a manner deviating from the CAN standard ISO 11898-1,
in which case, in order to determine the size of the data field if the further changeover condition (UB1) is present, the values of the four bits in the data length code are interpreted as at least partially deviating from the CAN standard ISO 11898-1.

9. Method according to Claim 8,
**characterized in that,** if the further changeover condition (UB1) is present, each of the possible value combinations of the bits in the data length code is assigned one of the permissible sizes of the data field.

10. Method according to either of Claims 8 and 9,
**characterized in that** the messages, in which the data field of the messages may comprise more than eight bytes in a manner deviating from the CAN standard ISO 11898-1 and, in order to determine the size of the data field, the values of the four bits in the data length code are interpreted as at least partially deviating from the CAN standard ISO 11898-1, can be distinguished from messages according to the CAN standard by means of a suitable identification (K1) in the arbitration field and/or in the control field.

11. Method according to one of Claims 8 to 10,
**characterized in that** the further changeover condition (UB1) is derived from the associated changeover condition (UB3) or matches it.

12. Method according to one of Claims 8 to 11,
**characterized in that** the suitable identification (K1) is evaluated in the participating data processing units in order to determine the further changeover condition (UB1) and the receiving process is adapted to the size of the data field depending on the further changeover condition (UB1).

13. Method according to one of Claims 8 to 12,
**characterized in that** the values between 0b0001 and 0b1000 of the data length code are used for the sizes of the data field between 1 and 8 bytes according to the CAN standard ISO 11898-1 and the remaining values of the data length code are used for the further permissible sizes of the data field up to the maximum possible size if the further changeover condition (UB1) is present.

14. Method according to one of Claims 8 to 13,
**characterized in that** the four bits in the data length code are interpreted as at least partially deviating from the CAN standard ISO 11898-1 if an additional changeover condition (UB2) is present and as deviating from the assignment if the additional changeover condition is not present.

15. Method according to Claim 14,
**characterized in that** the messages, in which the four bits in the data length code are intended to be interpreted as at least partially deviating from the CAN standard ISO 11898-1 if an additional changeover condition (UB2) is present and as deviating from the assignment if the additional changeover condition is not present, can be identified by means of an additional identification (K2) in the arbitration field and/or in the control field.

16. Method according to one of Claims 1 to 15,
**characterized in that** the temporal bit length inside a message can assume at least two different values depending on the value of a fourth changeover condition (UB4), the temporal bit length being greater than or equal to a predefined minimum value of approximately one microsecond for at least one first predefinable region inside the message and the temporal bit length having a value which is reduced in comparison with the first region in at least one second predefinable region inside the message.

17. Method according to Claim 16,
**characterized in that** the at least two different values of the temporal bit length are achieved inside a message by using at least two different scaling factors for the purpose of setting the bus time unit relative to a smallest time unit or the oscillator clock during ongoing operation.

18. Method according to either of Claims 16 and 17,
**characterized in that** the messages, in which the temporal bit length inside a message can assume at least two different values depending on the value of a fourth changeover condition (UB4), can be identified by means of a fourth identification (K4) in the arbitration field and/or in the control field, the fourth identification being able to match the first and/or third identification (K1, K3).

19. Method according to one of Claims 16 to 18,
**characterized in that** the value of the fourth changeover condition (UB4) is determined in the participating data processing units on the basis of the fourth identification (K4) or matches the further changeover condition (UB1) and/or the associated changeover condition (UB3) or is derived from the further changeover condition (UB1) and/or the associated changeover condition (UB3), the receiving process being adapted to the different values of the bit length inside a message depending on the value of the fourth changeover condition.

20. Method according to one of Claims 2 to 9,
**characterized in that** at least one of the suitable identifications (K1, K3) is effected by means of a first identification bit (EDL), the position of which is between the last bit of the identifier and the first bit in the data length code and at the position of which there is a bit having a defined value in messages according to the CAN standard ISO 11898-1.

21. Method according to one of Claims 15 to 20,
**characterized in that** the additional identification (K2) is effected by means of a second identification bit which is between the first identification bit (EDL) and the first bit in the data length code.

22. Method according to one of Claims 18 to 21,
**characterized in that** the fourth identification (K4) is effected by means of a further identification bit (BRS) which is between the first identification bit (EDL) and the first bit in the data length code.

23. Method according to one of Claims 1 to 22,
**characterized in that** the messages are transmitted in a time-controlled manner according to the method described in the TTCAN standard ISO 11898-4.

24. Apparatus for serially transmitting data in a bus system having at least two participating data processing units which interchange messages via the bus,
the transmitted messages having a logical structure according to the CAN standard ISO 11898-1,
the logical structure comprising a start-of-frame bit, an arbitration field, a control field, a data field, a CRC field, an acknowledge field and an end-of-frame sequence,
the control field comprising a data length code containing an item of information relating to the length of the data field,
**characterized in that** the CRC field of the messages may have at least two different numbers of bits at least depending on the value of an associated changeover condition (UB3),
wherein, at the beginning of a message, the calculation of at least two CRC checksums is started in a parallel manner using different generator polynomials.

25. Apparatus according to Claim 24,
**characterized in that** the apparatus is set up, by means of suitable means, to carry out at least one of the methods for transmitting data according to Claims 2 to 23.

26. Apparatus according to Claim 25,
**characterized in that** the suitable means comprise a sufficient number of shift registers to calculate the content of the CRC field by means of the at least two different generator polynomials.

27. Use of the method according to one of Claims 1 to 23 during normal operation of a motor vehicle or an industrial installation for transmitting data between at least two control devices of the motor vehicle or of the industrial installation which are connected via a suitable data bus.

28. Use of the method according to one of Claims 1 to 23 during the production or maintenance of a motor vehicle or of an industrial installation for transmitting data between a programming unit connected to a suitable data bus for the purpose of programming and at least one control device of the motor vehicle or of the industrial installation which is connected to the data bus.

## Revendications

1. Procédé de transfert de données en série dans un système de bus doté d'au moins deux unités participantes de traitement de données qui échangent des données par l'intermédiaire du bus,
les messages envoyés présentant une structure logique selon la norme CAN ISO 11898-1,
la structure logique comprenant un bit de début de trame, un champ d'arbitrage, un champ de contrôle, un champ de données, un champ CRC, un champ d'accusé de réception et une séquence de fin de trame,
le champ de contrôle comprenant un code de longueur de données qui contient une information concernant la longueur du champ de données,
**caractérisé en ce que** le champ CRC des messages peut présenter au moins deux nombres différents de bits en fonction de la valeur d'une condition de commutation associée (UB3),
au début d'un message, le calcul d'au moins deux sommes de vérification CRC étant lancé en parallèle au moyen de polynômes générateurs différents.

2. Procédé selon la revendication 1,
**caractérisé en ce que** pour déterminer le contenu du champ CRC en fonction de la valeur de la condition de commutation associée (UB3), on utilise au moins deux polynômes générateurs différents.

3. Procédé selon la revendication 1 ou 2,
**caractérisé en ce que**, pour au moins une valeur de la condition de commutation associée (UB3), le nombre de bits dans le champ CRC et le polynôme générateur utilisé pour déterminer le contenu du champ CRC correspondent à la norme CAN ISO 11898-1.

4. Procédé selon l'une des revendications 1 à 3, **caractérisé en ce que** les messages dans lesquels le champ CRC des messages peut présenter au moins deux nombres différents de bits en fonction de la valeur d'une condition de commutation associée (UB3) peuvent être détectés par une caractérisation appropriée (K1, K3) présente dans le champ d'arbitrage et/ou dans le champ de contrôle.

5. Procédé selon l'une des revendications 1 à 4, **caractérisé en ce que** la valeur de la condition de commutation associée (UB3) est déterminée dans les unités participantes de traitement de données en fonction de la caractérisation appropriée (K1, K3) ou est déduite en association avec le contenu du code de longueur de données, l'opération de réception étant adaptée à la taille du champ CRC en fonction de la valeur de la condition de commutation associée (UB3).

6. Procédé selon l'une des revendications 1 à 5, **caractérisé en ce qu'**il est décidé quel résultat d'un des calculs CRC lancé en parallèle est utilisé en fonction de la valeur de la condition de commutation associée (UB3).

7. Procédé selon l'une des revendications 1 à 6, **caractérisé en ce qu'**en cas de présence de la condition de commutation associée (UB3), lorsqu'au moins un des calculs CRC est exécuté en parallèle, on tient compte également de bits éventuels de remplissage à l'intérieur des parties du message situées en avant du champ CRC.

8. Procédé selon l'une revendications 1 à 7, **caractérisé en ce que**
en cas de présence d'une autre condition de commutation (UB1), le champ de données des messages peut comprendre à la différence de la norme CAN ISO 11898-1 plus de 8 octets et
**en ce que** pour déterminer la longueur du champ de données lors de la présence de l'autre condition de commutation (UB1), la valeur des quatre bits du code de longueur de données est interprétée au moins en partie de manière différente de celle' de la norme CAN ISO 11898-1.

9. Procédé selon la revendication 8, **caractérisé en ce que**, lors de la présence de l'autre condition de commutation (UB1), une des grandeurs admissibles du champ de données est associée à chacune des combinaisons possibles de valeurs des bits du code de longueur de données.

10. Procédé selon l'une des revendications 8 ou 9, **caractérisé en ce que** les messages dans lesquels le champ de données des messages peut comporter plus de 8 bits à la différence de la norme CAN ISO 11898-1 et dans lesquels les valeurs des quatre bits du code de longueur de données sont interprétées au moins en partie de manière différente de celles de la norme CAN ISO 11898-1 pour déterminer la grandeur du champ de données peuvent être distingués de messages selon la norme CAN par une caractérisation appropriée (K1) présente dans le champ d'arbitrage et/ou dans le champ de contrôle.

11. Procédé selon l'une des revendications 8 à 10, **caractérisé en ce que** l'autre condition de commutation (UB1) est déduite de la condition de commutation associée (UB3) ou correspond à celle-ci.

12. Procédé selon l'une des revendications 8 à 11, **caractérisé en ce que** la caractérisation appropriée (K1) est évaluée dans les unités participantes de traitement de données pour déterminer l'autre condition de commutation (UB1) et **en ce que** le processus de réception est adapté à la taille du champ de données en fonction de l'autre condition de commutation (UB1).

13. Procédé selon l'une des revendications 8 à 12, **caractérisé en ce que** les valeurs entre 0b0001 et 0b1000 du code de longueur de données sont utilisées pour les tailles de champ de données comprises entre 1 et 8 bits selon la norme CAN ISO 11898-1 et **en ce qu'**en cas de présence de l'autre condition de commutation (UB1), les autres valeurs du code de longueur de données sont utilisées pour les autres tailles admissibles du champ de données jusqu'à la taille maximale possible.

14. Procédé selon l'une des revendications 8 à 13, **caractérisé en ce qu'**en cas de présence d'une condition de commutation supplémentaire (UB2), les quatre bits du code de longueur de données sont interprétés au moins en partie de manière différente de celles de la norme CAN ISO 11898-1 et de manière différente de l'association qui prévaut lorsque la condition de commutation supplémentaire n'est pas présente.

15. Procédé selon la revendication 14, **caractérisé en ce que** les messages dans lesquels, en cas de présence d'une condition de commutation supplémentaire (UB2), les quatre bits du code de longueur de données doivent être interprétés au moins en partie de manière différente de celles de la norme CAN ISO 11898-1 et de manière différente de l'association qui prévaut lorsque la condition de commutation supplémentaire n'est pas présente, peuvent être détectés par une caractérisation supplémentaire (K2) présente dans le champ d'arbitrage et/ou dans le champ de contrôle.

16. Procédé selon l'une des revendications 1 à 15, **caractérisé en ce que** la longueur temporelle de bits à l'intérieur d'un message peut prendre au moins deux valeurs différentes en fonction de la valeur d'une quatrième condition de commutation (UB4), la longueur temporelle des bits étant supérieure ou égale à une valeur minimale prédéterminée d'environ une microseconde pour au moins une première plage prédéterminée à l'intérieur du message et la longueur temporelle des bits présentant une valeur plus petite que celle de la première plage dans au moins une deuxième plage prédéterminée à l'intérieur du message.

17. Procédé selon la revendication 16, **caractérisé en ce que** les deux ou plusieurs valeurs différentes des longueurs temporelles de bits à l'intérieur d'un message sont réalisées en permanence par recours à au moins deux facteurs d'échelle différents en vue du réglage de l'unité de temps du bus par rapport à l'unité de temps la plus petite ou à la cadence d'oscillateur.

18. Procédé selon l'une des revendications 16 ou 17, **caractérisé en ce que** les messages dans lesquels la longueur temporelle des bits peut prendre au moins deux valeurs différentes à l'intérieur d'un message en fonction de la valeur d'une quatrième condition de commutation (UB4) peuvent être détectés par une quatrième caractérisation (K4) présente dans le champ d'arbitrage et/ou le champ de contrôle, la quatrième caractérisation pouvant correspondre à la première et/ou à la troisième caractérisation (K1, K3).

19. Procédé selon l'une des revendications 16 à 18, **caractérisé en ce que** la valeur de la quatrième condition de commutation (UB4) est déterminée dans les unités participantes de traitement de données en fonction de la quatrième caractérisation (K4) ou correspond à l'autre condition de commutation (UB1) et/ou à la condition de commutation associée (UB3) ou est déduite de l'autre condition de commutation (UB1) et/ou de la condition de commutation associée (UB3), l'opération de réception étant adaptée aux valeurs différentes des longueurs de bits à l'intérieur d'un message en fonction de la valeur de la quatrième condition de commutation.

20. Procédé selon l'une des revendications 2 à 19, **caractérisé en ce qu'**au moins une des caractérisations appropriées (K1, K3) s'effectue par un premier bit de caractérisation (EDL) dont la position est située entre le dernier bit de l'identificateur et le premier bit du code de longueur de données et à la position duquel se trouve un bit de valeur définie dans les messages selon la norme CAN ISO 11898-1.

21. Procédé selon l'une des revendications 15 à 20, **caractérisé en ce que** la caractérisation supplémentaire (K2) s'effectue par un deuxième bit de caractérisation qui est situé entre le premier bit de caractérisation (EDL) et le premier bit du code de longueur de données.

22. Procédé selon l'une des revendications 18 à 21, **caractérisé en ce que** la quatrième caractérisation (K4) s'effectue par un autre bit de caractérisation (BRS) situé entre le premier bit de caractérisation (EDL) et le premier bit du code de longueur de données.

23. Procédé selon l'une des revendications 1 à 22, **caractérisé en ce que** les messages sont transmis sous commande temporelle selon le procédé décrit dans la norme TTCAN ISO 11898-4.

24. Dispositif de transfert de données en série dans un système de bus présentant au moins deux unités participantes de traitement de données qui échangent des messages par l'intermédiaire du bus,
les messages envoyés présentant une structure logique selon la norme CAN ISO 11898-1,
la structure logique comprenant un bit de début de trame, un champ d'arbitrage, un champ de contrôle, un champ de données, un champ CRC, un champ d'accusé de réception et une séquence de fin de trame,
le champ de contrôle comprenant un code de longueur de données qui contient une information concernant la longueur du champ de données,
**caractérisé en ce que**
le champ CRC des messages peut présenter au moins deux nombres différents de bits au moins en fonction de la valeur d'une condition de commutation associée (UB3),
au début d'un message, le calcul d'au moins deux sommes de vérification CRC étant lancé en parallèle au moyen de polynômes générateurs différents.

25. Dispositif selon la revendication 24, **caractérisé en ce que** le dispositif est conçu pour exécuter par des moyens appropriés au moins un des procédés de transfert de données selon les revendications 2 à 23.

26. Dispositif selon la revendication 25, **caractérisé en ce que** les moyens appropriés comprennent un nombre suffisant de registres à décalage pour calculer le contenu du champ CRC au moyen des au moins deux polynômes générateurs différents.

27. Utilisation du procédé selon l'une des revendications 1 à 23 dans le fonctionnement normal d'un véhicule automobile ou d'une installation industrielle, pour la transmission de données entre au moins deux appareils de commande du véhicule automobile ou de l'installation industrielle, qui sont reliés par un bus de données approprié.

28. Utilisation du procédé selon l'une des revendications 1 à 23 pendant la fabrication ou l'entretien d'un véhicule automobile ou d'une installation industrielle, pour le transfert de données entre une unité de programmation reliée à un bus de données approprié en vue de la programmation et au moins un appareil de commande du véhicule automobile ou de l'installation industrielle qui est raccordé au bus de données.
